# EUROPEAN PATENT APPLICATION

(11) **EP 4 343 604 A1**
(43) Date of publication of application: **27.03.2024**
(21) Application number: 23199524.2
(22) Date of filing: 25.09.2023
(51) Int. Cl.: G06F 30/12, G06F 30/27, G06F 40/56, G06N 3/045, G06N 3/047, G06N 3/08, G06N 3/088, G06N 20/00

(54) **TECHNIQUES FOR USING MULTIMODAL MACHINE LEARNING MODELS TO GENERATE DESIGN ALTERNATIVES FOR THREE-DIMENSIONAL OBJECTS**

(30) Priority: 26.09.2022 US 202263377104 P; 08.08.2023 US 202318446339
(71) Applicant: Autodesk, Inc., San Francisco, CA 94105 (US)
(72) Inventor: LIU, Vivian, San Francisco, 94105 (US); VERMEULEN, Jo Karel, San Francisco, 94105 (US); FITZMAURICE, George William, San Francisco, 94105 (US); MATEJKA, Justin Frank, San Francisco, 94105 (US)
(74) Representative: Morrall, Jonathan Ian McLachlan

(57) **Abstract**

In various embodiments, a design exploration application (130) generates images that represent design alternatives for three-dimensional (3D) objects. The design exploration application (130) generates a keyword prompt based on design intent text that describes a 3D object. The design exploration application (130) executes a first machine learning model on the keyword prompt to generate a first set of keywords. The design exploration application (130) generates a rephrase prompt based on a second set of keywords that includes at least one keyword from the first set of keywords. The design exploration application (130) executes the first machine learning model on the rephrase prompt to generate a final text prompt. The design exploration application (130) executes a second machine learning model on the final text prompt to generate a set of images.

## Description

### CROSS-REFERENCE TO RELATED APPLICATIONS

This application claims priority benefit of the United States Provisional Patent Application titled "ARTIFICIAL INTELLIGENCE-BASED TECHNIQUES FOR INTEGRATING TEXT INTO IMAGES," filed on September 26, 2022, and having Serial No. 63/377,104. The subject matter of this related application is hereby incorporated herein by reference.

### BACKGROUND

### Field of the Various Embodiments

The various embodiments relate generally to computer-aided design and artificial intelligence and, more specifically, to techniques for using multimodal machine learning models to generate design alternatives for three-dimensional objects.

### Description of the Related Art

Design exploration for three-dimensional (3D) objects generally refers to an exploration phase of an overall design process during which a designer generates and evaluates numerous high-level design alternatives for one or more 3D objects. As is well-understood in practice, manually generating numerous diverse high-level design alternatives for even a relatively simple 3D object can be very labor-intensive and time-consuming. Because the time allocated for design exploration is usually limited, only a relatively small number of design alternatives can typically be generated and evaluated during a normal design process, which can reduce the overall quality of the final 3D objects developed for a design. Accordingly, various conventional computer-aided design applications have been developed that attempt to automate more fully how 3D objects are generated and evaluated.

One approach to automating how 3D objects are generated and evaluated involves implementing a generative design application to automatically synthesize design alternatives for a 3D object based on any number of quantitative goals and physical and functional constraints. In a typical design exploration flow, a generative design application executes various optimization algorithms to generate numerous (e.g., tens of thousands) design alternatives that satisfy the applicable quantitative goals and physical and functional constraints. The generative design application then presents the generated design alternatives to a user in the context of a design space. The user subsequently explores the design space, manually viewing and evaluating different design alternatives included in the design space in an attempt to select the best design alternative to incorporate into an overall design or to use for additional design and/or manufacturing activities.

One drawback of the above approach is that determining a set of nonconflicting, quantitative goals and physical and functional constraints that define an appropriate design space for a 3D object oftentimes requires significant knowledge of physics and engineering as well as a non-trivial familiarity with the generative design application. If a user lacks the underlying knowledge required to define the design space properly, then many design alternatives that satisfy the actual design requirements and are more optimized with respect to the actual design goals at-hand can end up being inadvertently omitted from the design space. In such cases, the user typically ends up selecting inferior design alternatives, which can substantially reduce the overall quality of the final 3D object.

For example, a user that does not have the expertise to properly calculate load requirements could use a generative design application to generate designs automatically based on a size-reduction goal and unnecessarily high minimum load constraints. The resulting "over-constrained" design space could include designs that have bulky structural reinforcements that satisfy the unnecessarily high minimum load constraints while omitting smaller, more streamlined designs that satisfy the actual load requirements but not the unnecessarily high minimum load constraints. In such a scenario, the user could end-up selecting a design alternative that is associated with an unnecessarily bulky final 3D object.

As the foregoing illustrates, what is needed in the art are more effective techniques for automatically generating and evaluating design alternatives for 3D objects.

### SUMMARY

One embodiment sets forth a computer-implemented method for generating images that represent design alternatives for three-dimensional (3D) objects. In some embodiments, the method includes generating a first keyword prompt based on design intent text that describes at least a first 3D object; executing a first machine learning model on the first keyword prompt to generate a first set of keywords; generating a rephrase prompt based on a second set of keywords that includes at least one keyword included in the first set of keywords; executing the first machine learning model on the rephrase prompt to generate a final text prompt; and executing a second machine learning model on the final text prompt to generate a set of images.

At least one technical advantage of the disclosed techniques relative to the prior art is that the disclosed techniques enable users with limited or no knowledge of physics, engineering, and/or generative design to more effectively explore design spaces for 3D objects. In that regard, the disclosed techniques provide an automated process for generating images representing different design alternatives for 3D objects based on user-based design-related intentions expressed via qualitative user input. Because no quantitative user input is required with the disclosed techniques, the likelihood that users having limited or no knowledge of physics, engineering, and/or generative design are able to define proper design spaces when designing and evaluating 3D objects using the disclosed techniques is increased relative to what is commonly achievable using prior art generative design techniques. Accordingly, with the disclosed techniques, 3D objects that align better with the actual design-oriented intentions of users can be more readily generated and manufactured. These technical advantages provide one or more technological improvements over prior art approaches.

### BRIEF DESCRIPTION OF THE DRAWINGS

So that the manner in which the above recited features of the various embodiments can be understood in detail, a more particular description of the inventive concepts, briefly summarized above, may be had by reference to various embodiments, some of which are illustrated in the appended drawings. It is to be noted, however, that the appended drawings illustrate only typical embodiments of the inventive concepts and are therefore not to be considered limiting of scope in any way, and that there are other equally effective embodiments.
Figure 1 is a conceptual illustration of a system configured to implement one or more aspects of the various embodiments;
Figure 2 is an exemplar illustration of the design intent panel of Figure 1, according to various embodiments; and
Figures 3A and 3B set forth a flow diagram of method steps for generating images representing design alternatives for 3D objects, according to various embodiments.

### DETAILED DESCRIPTION

In the following description, numerous specific details are set forth to provide a more thorough understanding of the various embodiments. However, it will be apparent to one skilled in the art that the inventive concepts may be practiced without one or more of these specific details. For explanatory purposes, multiple instances of like objects are symbolized with reference numbers identifying the object and parenthetical numbers(s) identifying the instance where needed.

### System Overview

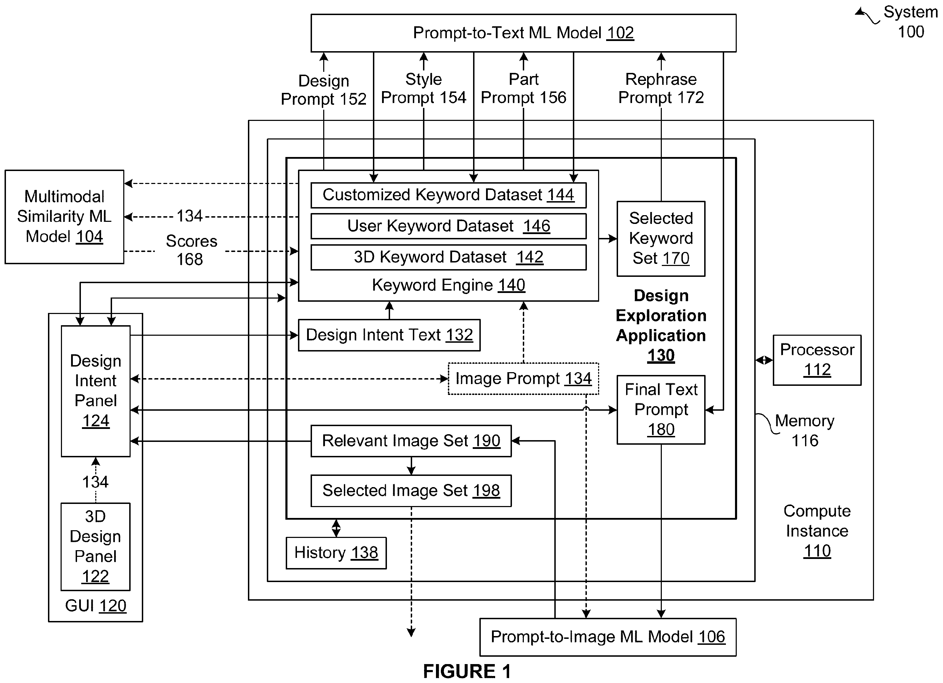

Figure 1 is a conceptual illustration of a system 100 configured to implement one or more aspects of the various embodiments. As shown, in some embodiments, the system 100 includes, without limitation, a compute instance 110, a graphical user interface (GUI) 120, a prompt-to-text machine learning (ML) model 102, a multimodal similarity ML model 104, and a prompt-to-image ML model 106. In some other embodiments, the system 100 can include any number and/or types of other compute instances, GUIs, or any combination thereof. In the same or other embodiments, the multimodal similarity ML model 104 can be omitted or replaced with any other type of model.

Any number of the components of the system 100 can be distributed across multiple geographic locations or implemented in one or more cloud computing environments (e.g., encapsulated shared resources, software, data) in any combination. In some embodiments, the compute instance 110 and/or zero or more other compute instances can be implemented in a cloud computing environment, implemented as part of any other distributed computing environment, or implemented in a stand-alone fashion.

As shown, the compute instance 110 includes, without limitation, a processor 112 and a memory 116. In some embodiments, each of any number of other compute instances can include any number of other processors and any number of other memories in any combination. In particular, the compute instance 110 and/or one or more other compute instances can provide a multiprocessing environment in any technically feasible fashion.

The processor 112 can be any instruction execution system, apparatus, or device capable of executing instructions. For example, the processor 112 could comprise a central processing unit, a graphics processing unit, a controller, a microcontroller, a state machine, or any combination thereof. The memory 116 stores content, such as software applications and data, for use by the processor 112.

The memory 116 can be one or more of a readily available memory, such as random-access memory, read only memory, floppy disk, hard disk, or any other form of digital storage, local or remote. In some embodiments, a storage (not shown) may supplement or replace the memory 116. The storage may include any number and type of external memories that are accessible to the processor 112 of the compute instance 110. For example, and without limitation, the storage can include a Secure Digital Card, an external Flash memory, a portable compact disc read-only memory, an optical storage device, a magnetic storage device, or any suitable combination of the foregoing.

In some embodiments, the compute instance 110 can be integrated with any number and/or types of other devices (e.g., one or more other compute instances and/or a display device) into a user device. Some examples of user devices include, without limitation, desktop computers, laptops, smartphones, and tablets.

In general, the compute instance 110 is configured to implement one or more software applications. For explanatory purposes only, each software application is described as residing in the memory 116 of the compute instance 110 and executing on the processor 112 of the compute instance 110. In some embodiments, any number of instances of any number of software applications can reside in the memory 116 and any number of other memories associated with any number of other compute instances and execute on the processor 112 of the compute instance 110 and any number of other processors associated with any number of other compute instances in any combination. In the same or other embodiments, the functionality of any number of software applications can be distributed across any number of other software applications that reside in the memory 116 and any number of other memories associated with any number of other compute instances and execute on the processor 112 and any number of other processors associated with any number of other compute instances in any combination. Further, subsets of the functionality of multiple software applications can be consolidated into a single software application.

In particular, the compute instance 110 is configured to generate design alternatives for 3D objects. As described previously herein, one conventional approach to automatically generating design alternatives for 3D object involves implementing a generative design application. In operation, the generative design application automatically synthesizes design alternatives for a 3D object based on any number of quantitative goals and physical and functional constraints. The generative design application then presents the generated design alternatives to a user in the context of a design space that the user can explore in an attempt to select one or more design alternative for use for additional design and/or manufacturing activities.

One drawback of the above approach is that determining a set of nonconflicting, quantitative goals and physical and functional constraints that define an appropriate design space for a 3D object oftentimes requires significant knowledge of physics and engineering as well as a non-trivial familiarity with the generative design application. If a user is unable to define the design space properly, then many design alternatives that satisfy the actual design requirements and are more optimized with respect to the actual design goals at-hand can end up being inadvertently omitted from the design space. In such cases, the user typically ends up selecting one or more inferior design alternatives. As a result, the overall quality of the final 3D object can be substantially reduced.

### Generating Images Representing Design Alternatives for 3D Objects

To address the above problems, the system 100 includes, without limitation, a design exploration application 130. As described in greater detail below, the design exploration application 130 interacts with a user via the GUI 120 in order to generate a final text prompt 180 and optionally an image prompt 134 that effectively describe design-related intentions. The design exploration application 130 then executes the prompt-to-image ML model 106 on the final text prompt 180 and optionally the image prompt 134 to generate a relevant image set 190 representing different design alternatives for a 3D object. The design exploration application 130 displays the relevant image set 190 within the GUI 120. The user can select via the GUI 120 one or more images from the relevant image set 190 to use in additional design and/or manufacturing activities.

As shown, the design exploration application 130 resides in the memory 116 of the compute instance 110 and executes on the processor 112 of the compute instance 110. The design exploration application 130 interacts with a user via the GUI 120. In some embodiments, both the design exploration application 130 and a 3D design application (not shown) interact with the same user via the GUI 120.

The GUI 120 can be any type of user interface that allows users to interact with one or more software applications via any number and/or types of GUI elements. The GUI 120 can be displayed in any technically feasible fashion on any number and/or types of stand-alone display device, any number and/or types of display screens that are integrated into any number and/or types of user devices, or any combination thereof. A user device can be any device that is capable of displaying any amount and/or type of media content on one or more associated display devices, one or more associated display screens, or any combination thereof. Some examples of user devices include desktop computers, laptops, smartphones, smart televisions, and tablets.

The design exploration application 130 can perform any number and/or types of operations to directly and/or indirectly display and monitor any number and/or types of interactive GUI elements and/or any number and/or types of non-interactive GUI elements within the GUI 120. In some embodiments, each interactive GUI element enables one or more types of user interactions that automatically trigger corresponding user events. Some examples of types of interactive GUI elements include, without limitation, scroll bars, buttons, text entry boxes, drop-down lists, and sliders. In some embodiments, the design exploration application 130 organizes GUI elements into one or more container GUI elements (e.g., panels and/or panes).

The design exploration application 130 generates images representing different design alternatives for 3D objects in accordance with user-based design-related intentions expressed via user input. In some embodiments, the design exploration application 130 enables selection of one or more of the images for further design activities.

For explanatory purposes only, the functionality of the design exploration application 130 is described herein in the context of exemplar interactive and linear workflows used to generate the relevant image set 190 and the selected image set. 198 in accordance with user-based design-related intentions expressed during the workflow. The relevant image set 190 includes, without limitation, one or more images and any amount (including none) and/or types of associated metadata. Each image included in the relevant image set 190 represents a design alternative for a target 3D object.

As persons skilled in the art will recognize, the techniques described herein are illustrative rather than restrictive and can be altered and applied in other contexts without departing from the broader spirit and scope of the inventive concepts described herein. For example, the techniques described herein can be modified and applied to generate any number of relevant image sets associated with any target 3D object set in a linear fashion, a nonlinear fashion, an iterative fashion, a non-iterative fashion, a recursive fashion, a non-recursive fashion, or any combination thereof during an overall process for generating and evaluating design alternatives for that target 3D object set. A target 3D object set can include any number (including one) and/or types of target 3D objects.

For instance, in some embodiments, a first relevant image set can be generated and displayed within the GUI 120 during a first iteration, any portion (including all) of a first image included in the first relevant image set can be selected via the GUI 120, and a first image prompt can be set equal to the selected portion of the first image to recursively generate a second relevant image set during a second iteration. In the same or other embodiments, the design exploration application 130 can display and/or re-display any number of GUI elements, generate and/or regenerate any amount of data, or any combination thereof any number of times and/in any order while generating each new relevant image set.

As shown, in some embodiments, the design exploration application 130 includes, without limitation, design intent text 132, a keyword engine 140, a selected keyword set 170, a final text prompt 180, a relevant image set 190, and a selected image set 198. In the same of other embodiments, the design exploration application 130 further includes an image prompt 134 (depicted via a dashed arrow).

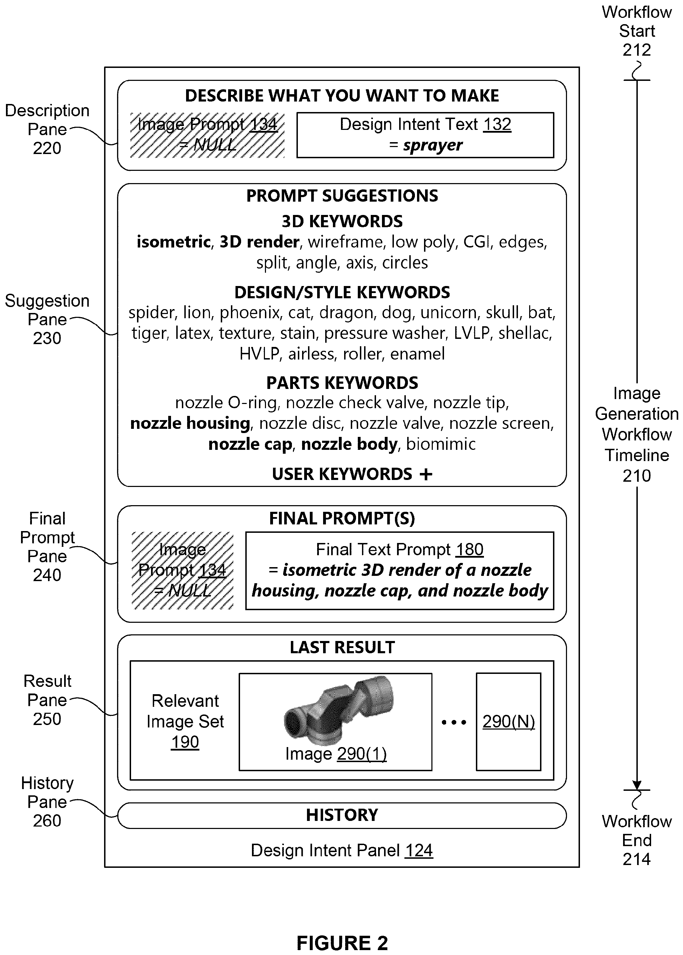

To initiate the exemplar interactive and linear workflow, the design exploration application 130 displays a design intent panel 124 within the GUI 120. The design intent panel 124 can include any number and/or types of interactive GUI elements and any number and/or types of non-iterative GUI elements that can be organized in any technically feasible fashion. As described in greater detail below in conjunction with Figure 2, in some embodiments, at least some GUI elements included in the design intent panel 124 includes GUI are organized into a description pane, a suggestion pane, a final prompt pane, a result pane, and a history pane.

The design intent panel 124 enables a user to specify the design intent text 132 and optionally the image prompt 134. The design intent text 132 can be any textual user input that represents any number and/or types of design-related intentions associated with one or more target 3D objects. Some examples of design intent text 132 are "sprayer," "subwoofer," "prosthetic hand," and "a sports car built like a Lego building block,"

The image prompt 134 can include any number of images that represent any number and/or types of design-related intentions associated with one or more target 3D objects. In some embodiments, the design exploration application 130 sets the image prompt 134 equal to any number and/or types of images selected by the user via the GUI 120. In some other embodiments (depicted within the GUI 120 via a dashed arrow) the design exploration application 130 captures the image prompt 134 from a 3D design displayed by a 3D design application (not shown) in a 3D design panel 122 within the GUI 120. The design exploration application 130 and/or the 3D design application can capture the image prompt 134 from a 3D design in any technically feasible fashion. For instance, in some embodiments, the design exploration application 130 renders a viewport associated with the 3D design panel 122 to generate the image prompt 134.

As shown, the keyword engine 140 includes, without limitation, a 3D keyword dataset 142, a customized keyword dataset 144, and a user keyword dataset 146. The 3D keyword dataset 142 includes any number and/or types of 3D keywords and any amount (including none) and/or types of associated metadata. The customized keyword dataset 144 includes any number and/or types of customized keywords and any amount (including none) and/or types of associated metadata. The user keyword dataset 146 includes any number and/or types of user keywords and any amount (including none) and/or types of associated metadata.

As used herein, a "keyword" can be any word or phrase. More specifically, a 3D keyword can be any word or phrase relevant to designing 3D objects. A customized keyword can be any word or phrase describing or otherwise relevant to any aspect of the design intent text 132. A user keyword can be any word of phrase specified by a user.

The 3D keywords included in the 3D keyword dataset 142 are examples of design language often associated with 3D modeling. The design exploration application 130 can determine the 3D keywords in any technically feasible fashion. For instance, in some embodiments, the design exploration application 130 implements a constant set of 3D keywords that includes high-frequency, general-purposes words and phrases previously identified from transcripts of a set of tutorials and other videos used to help users perform 3D design tasks.

The keyword engine 140 generates any number and/or types of customized keywords based on the design intent text 132. To generate the customized keywords, the keyword engine 140 constructs a different keyword prompt for each type of customized keyword based on the design intent text 132. Each type of customized keyword is associated with at least one aspect of designing 3D objects and/or 3D objects. In a complementary fashion, each keyword prompt is a request for knowledge on at least one aspect of 3D design and/or 3D objects that is relevant to the design intent text 132. For instance, in some embodiments, each keyword prompt is a request to list at least one of a design, a style, or a part associated with the design intent text 132. The keyword engine 140 executes the prompt-to-text ML model 102 on each of the keyword prompts to generate a different set of associated keywords.

The prompt-to-text ML model 102 comprises an ML model that has been trained on a relatively large amount of existing textual data and optionally any amount of existing image data to perform any number and/or types of prediction tasks based on patterns detected in the existing data. In particular, the prompt-to-text ML model 102 is trained to generate new textual data in response to text prompts that are optionally associated with any number and/or types of image prompts. As used herein, a text prompt includes any amount and/or types of textual data, and an image prompt includes any amount and/or types of image data. The prompt-to-text ML model 102 is also referred to herein as a generative prompt-to-text ML model.

If the prompt-to-text ML model 102 is trained based on both textual data and image data, then the prompt-to-text ML model 102 is also referred to herein as a multimodal ML model. For instance, in some embodiments, the prompt-to-text ML model 102 comprises a third-generation Generative Pre-Trained Transformer (GPT-3) model. If the prompt-to-text ML model 102 is trained based on only textual data, then the prompt-to-text ML model 102 is also referred to herein as a single modal ML model and a large language model. For instance, in some embodiments, the prompt-to-text ML model 102 comprises a fourth-generation Generative Pre-Trained Transformer (GPT-4) model. Techniques for implementing and using different multimodal ML models and different large language models are well-known in the art. For example, please see https://openai.com/product for information on implementing and using GPT-4 and GPT-3.

As described in more detail below in conjunction with Figure 2, in some embodiments, the customized keywords include design keywords, style keywords, and part keywords. A design keyword can be any word or phrase describing or otherwise relevant to one or more designs associated with the design intent text 132. A style keyword can be any word or phrase describing or otherwise relevant to one or more styles associated with the design intent text 132. A part keyword can be any word or phrase describing or otherwise relevant to one or more parts associated with the design intent text 132.

The keyword engine 140 generates a design prompt 152, a style prompt 154, and a part prompt 156. In some embodiments, the keyword engine 140 generates the design prompt 152 based on a parameterized string "list N popular 3D designs of a DIT," where N can be any integer and DIT denotes the design intent text 132. The keyword engine 140 generates the style prompt 154 based on a parameterized string "what are N popular styles of a DIT." The keyword engine 140 generates the part prompt 156 based on a parameterized string "what are N parts of a DIT.."

As shown, the keyword engine 140 executes the prompt-to-text ML model 102 on the design prompt 152 to generate the design keywords. The keyword engine 140 executes the prompt-to-text ML model 102 on the style prompt 154 to generate the style keywords. The keyword engine 140 executes the prompt-to-text ML model 102 on the part prompt 156 to generate the part keywords.

The keyword engine 140 generates any amount (including none) of metadata for each of the 3D keywords and each of the customized keywords. For instance, in some embodiments, the keyword engine 140 generates a selection flag and a score for each of the 3D keywords and each of the customized keywords. At any given point-in-time, a selection flag associated with a keyword indicates whether the keyword is currently selected via the design intent panel 124 by a user. The score associated with a keyword estimates a visual-semantic similarity between the image prompt 134 and the keyword.

If the image prompt 134 is not specified, then the keyword engine 140 sets the score of each keyword to a value (e.g., NULL) that indicates that the score is not applicable. If however, the image prompt 134 is specified, then the keyword engine 140 computes scores 168 based on the image prompt 134, the 3D keywords, and the customized keywords. The scores 168 includes a different score for each of the design keywords and each of the customized keywords. More specifically, for each of the 3D keywords and each of the customized keywords, the keyword engine 140 executes the multimodal similarity ML model 104 on the image prompt 134 and the keyword to generate the associated score.

The multimodal similarity ML model 104 comprises a multimodal ML model that has been trained on a relatively large amount of existing textual data and existing image data to generates scores that estimate visual-semantic similarity between text and images. For instance, in some embodiments, the multimodal similarity ML model 104 comprises a Contrastive Language-Image Pre-Training (CLIP) model, Techniques for implementing and using mutlimodal similarity ML models are well-known in the art. For example, please see https://openai.com/product for information on implementing and using CLIP.

After generating the 3D keyword dataset 142 and the customized keyword dataset 144, the keyword engine 140 sets the user keyword dataset 146 to a value (e.g., NULL) to indicate that no user keywords are defined. The keyword engine 140 then displays within the design intent panel 124 selectable versions of the 3D keywords and the customized keywords and one or more interactive GUI elements that enable optional text entry of any number of user keywords

Notably, if the image prompt 134 is specified, then the keyword engine 140 visually indicates within the design intent panel 124 the similarity of the 3D keywords and the customized keywords to the image prompt 134 as per the associated scores. To visually indicate the similarity of a keyword to the image prompt 134, the keyword engine 140 sets at least one visual characteristics of the selectable version of the keyword based on the score associated with the keyword. For instance, in some embodiments, the keyword engine 140 sets at least one of a color, an intensity, an opacity, a size, or a position of a selectable version of a keyword based on the score associated with the keyword.

For example, the keyword engine 140 could set an opacity of a highlight associated with a selectable version of the keyword based on the associated score. More specifically, the keyword engine 140 could cause a keyword having a relatively high score to be strongly highlighted within the design intent panel 124. By contrast, a the keyword engine 140 could cause a keyword having a relative low score would be weakly highlighted within the design intent panel 124.

The keyword engine 140 interactively updates selection flags associated with keywords and optionally designates one or more words and/or one or more phrases as new user keywords in accordance with user input received via the design intent panel 124 until detecting a final prompt trigger. After designating a word or a phrase as a new user keyword, the keyword engine 140 adds the new user keyword and optionally any amount and/or types of associated metadata to the user keyword dataset 146. In some embodiments, the metadata associated with the new user keyword includes a selection flag and score. The keyword engine 140 initializes the selection flag to indicate that the new user keyword is selected. If the image prompt 134 is specified, then the keyword engine 140 executes the multimodal similarity ML model 104 on the image prompt 134 and the new user keyword to generate a score for the new user keyword. If the image prompt 134 is not specified, then the keyword engine 140 sets the score of the new keyword to a value (e.g., NULL) that indicates that the score is not applicable. The keyword engine 140 then displays within the design intent panel 124 a selectable version of the new user keyword. If the image prompt 134 is specified, then the keyword engine 140 visually indicates within the design intent panel 124 the similarity of the new user score to the image prompt 134 as per the associated score.

The final prompt trigger can be any type of user input indicating that the design exploration application 130 is to generate the final text prompt 180 based on the currently selected keywords. Upon detecting the final prompt trigger, the design exploration application 130 sets the selected keyword set 170 to the subset of the 3D keywords, the customized keywords, and the user keywords that are currently selected as per the selection flags included in the 3D keyword dataset 142, the customized keyword dataset 144, and the user keyword dataset 146, respectively.

As shown, the design exploration application 130 constructs a rephrase prompt 172 based on the selected keyword set 170. The rephrase prompt 172 is a request to generate a textual prompt that reflects at least the selected keyword set 170. In some embodiments, the rephrase prompt 172 is request to combine every keyword included in the selected keyword set 170. The design exploration application 130 can generate the rephrase prompt 172 in any technically feasible fashion. For instance, in some embodiments, the design exploration application appends a list of each of the keywords included in the selected keyword set 170 to a string "put the following together: " to generate the rephrase prompt 172.

The design exploration application 130 executes the prompt-to-text ML model 102 on the rephrase prompt 172 to generate the final text prompt 180. The design exploration application 130 displays within the design intent panel 124 an editable version of the final text prompt 180. The keyword engine 140 optionally and interactively update the final text prompt 180 in accordance with user input received via the design intent panel 124 until detecting a result trigger.

The result trigger can be any type of user input indicating that the design exploration application 130 is to generate the relevant image set 190 based on the current version of the final text prompt 180. Upon detecting the result trigger, the design exploration application 130 generates the final text prompt based on the rephrase prompt 172 and optionally the image prompt 134. More specifically, if the image prompt 134 is specified, then the design exploration application 130 executes the prompt-to-image ML model 106 on both the final text prompt 180 and the image prompt 134 to generate the relevant image set 190. Otherwise, the design exploration application 130 executes the prompt-to-image ML model 106 on the final text prompt 180 to generate the relevant image set 190.

The prompt-to-image ML model 106 comprises an ML model that has been trained on a relatively large amount of existing textual data and a relatively large amount of existing image data to generate new image data in response to text prompts that are optionally associated with any number and/or types of image prompts. Because the prompt-to-image ML model 106 is trained based on both textual data and image data, the prompt-to-image ML model 106 is also referred to herein as a "multimodal ML model.: And because the prompt-to-image ML model 106 generates new image data, the prompt-to-image ML model 106 is also referred to herein as a generative prompt-to-image ML model.

In some embodiments, the prompt-to-image ML model 106 comprises a specialized version of a GPT-3 model referred to as a "DALL-E2" model. Techniques for implementing and using different multimodal ML models to generate new image data in response to text prompts that are optionally associated with image prompts are well-known in the art. For example, please see https://openai.com/dall-e-2 for information on implementing and using DALL-E2. In some other embodiments, the prompt-to-image ML model 106 is trained to generate new image data in response to text prompts but does not process image prompts, and the techniques described herein are modified accordingly.

The relevant image set 190 includes any number of images representing design alternatives associated with the final text prompt 180 and optionally the image prompt 134. Because the final text prompt 180 is generated based on the selected keyword set 170 and the selected keyword set 170 is generated based on the design intent text 132, the relevant image set 190 also reflects the selected keyword set 170 and the design intent text 132.

The design exploration application 130 displays within the design intent panel 124 selectable versions of the images included in the relevant image set 190. The design exploration application 130 interactively generates and updates the selected image set 198 based on user input received via the design intent panel 124. The selected image set 198 includes each image that is selected via the design intent panel 124 from the relevant image set 190.

The design exploration application 130 stores and/or transmits to any number and/or types of software applications the selected image set 198, the relevant image set 190, any data associated with the relevant image set 190, or any combination thereof. In some embodiments, the design exploration application 130 automatically and generates new summary dataset that includes any amount and/or types of data associated with generating the relevant image set 190 and/or the selected image set 198 and then stores the summary dataset in a history 138. As shown, the history 138 resides in the memory 116 of the compute instance 110.

One advantage of the disclosed techniques relative to the prior art is that because no quantitative user input is required to generate the relevant image set 190, the design exploration application 130 enables users with limited or no knowledge of physics, engineering, and/or generative design to effectively explore design spaces for 3D objects. Furthermore, because the keyword engine 140 automatically and graphically suggests keywords that are relevant to 3D design and various design-related characteristics associated with design intent texts the design exploration application 130 enables a user with limited or no knowledge of 3D design and/or design-related nomenclature associated with target 3D objects to construct productive final text prompts.

Another advantage of the disclosed techniques is that the computational complexity of the algorithms implemented by the design exploration application 130, the prompt-to-text ML model 102, the multimodal similarity ML model 104, and the prompt-to-image ML model 106 are substantially reduced relative to the computational complexity of the various optimization algorithms implemented by a conventional generative design application, . Consequently, the total amount of time required to generate each relevant image set associated with a 3D object can be substantially reduced relative to the amount of time required to generate a single set of design alternatives using a conventional generative design application.

It will be appreciated that the system 100 shown herein is illustrative and that variations and modifications are possible. For example, the functionality provided by GUI 120, the prompt-to-text ML model 102, the multimodal similarity ML model 104, the prompt-to-image ML model 106, the design exploration application 130, and the keyword engine 140 as described herein can be integrated into or distributed across any number and/or types of software applications (including one), and any number of components of the system 100. Further, the connection topology between the various units in Figure 1 can be modified as desired.

Please note that the techniques described herein are illustrative rather than restrictive and can be altered without departing from the broader spirit and scope of the embodiments. Many modifications and variations on the functionality of the compute instance 110, the GUI 120, the prompt-to-text ML model 102, the multimodal similarity ML model 104, the prompt-to-image ML model 106, the design exploration application 130, and the keyword engine 140 as described herein will be apparent to those of ordinary skill in the art without departing from the scope and spirit of the described embodiments.

Similarly, the storage, organization, amount, and/or types of data described herein are illustrative rather than restrictive and can be altered without departing from the broader spirit and scope of the embodiments. In that regard, many modifications and variations on the design intent text 132, the image prompt 134, the design prompt 152, the 3D keyword dataset 142, the user keyword dataset 146, the design prompt 152, the style prompt 154, the part prompt 156, the customized keyword dataset 144, the selected keyword set 170, the final text prompt 180, the relevant image set 190, the selected image set 198. and the data displayed within the GUI 120 as described herein will be apparent to those of ordinary skill in the art without departing from the scope and spirit of the described embodiments.

### Using ML Models to Generate Images Based on Design-Related Intentions

Figure 2 is an exemplar illustration of the design intent panel 124 of Figure 1, according to various embodiments. More specifically, Figure 2 is a conceptual illustration of some GUI elements as displayed within the design intent panel 124 at a point-in-time denoted as a workflow end 214. The workflow end 214 denotes the end of an exemplar image generation workflow executed via the design exploration application 130 to generate the relevant image set 190 associated with an exemplar 3D object (a sprayer).

For explanatory purposes, the workflow end 214 corresponds to a point-in-time immediately after the design exploration application 130 displays the relevant image set 190 associated with the sprayer within the design intent panel 124. In a complementary fashion, a workflow start 212 denotes the start of the exemplar image generation workflow. The workflow start 212 corresponds to a point-in-time immediately after the design exploration application 130 displays an initial, default version of the design intent panel 124.

As shown, the design intent panel 124 includes, without limitation, a description pane 220, a suggestion pane 230, a final prompt pane 240, a result pane 250, and a history pane 260. For explanatory purposes, an image generation workflow timeline 210 depicts the relative periods of time during which each of the description pane 220, the suggestion pane 230, and the final prompt pane 240 are updated by an exemplary user, the design exploration application 130, or both during the exemplar image generation workflow.

As shown, the description pane 220 includes a grayed-out image prompt 134 and an editable version of the design intent text 132. Throughout the execution of the exemplar image generation workflow, the image prompt 134 remains grayed-out, thereby indicating that the user does not select the image prompt 134 during the execution of the exemplar image generation workflow. The design intent text 132 is textual user input that is entered by the user via the description pane 220 after the workflow start 212. and remains unchanged through the workflow end 214.

As described previously herein in conjunction with Figure 1, in response to the entry of the design intent text 132, the keyword engine 140 generates the design prompt 152, the style prompt 154, and the part prompt 156. For the first iteration, the keyword engine 140 generates the design prompt 152, the style prompt 154, and the part prompt 156 based on the design intent text 132 of "sprayer." The design prompt 152 is "list ten popular 3D designs of a sprayer." The style prompt 154 is "what are ten popular styles of a sprayer." The part prompt 156 is "what are ten parts of a sprayer."

The keyword engine 140 executes the prompt-to-text ML model 102 on the design prompt 152 to generate the following ten design keywords: spider, lion, phoenix, cat, dragon, dog, unicorn, skull, bat, and tiger. The keyword engine 140 executes the prompt-to-text ML model 102 on the style prompt 154 to generate the following ten style keywords: latex, texture, stain, pressure washer, low-volume-low-pressure (LVLP), shellac, high-volume-low-pressure (HVLP), airless, roller, and enamel. The keyword engine 140 executes the prompt-to-text ML model 102 on the part prompt 156 to generate the following ten part keywords: nozzle O-ring, nozzle check valve, nozzle tip, nozzle housing, nozzle disc, nozzle valve, nozzle screen, nozzle cap, nozzle body, and biomimic. Referring back to Figure 1, the keyword engine 140 generates the customized keyword dataset 144 that represents the design keywords, the style keywords, and the part keywords.

As described previously herein in conjunction with Figure 1, the keyword engine 140 automatically updates the suggestion pane 230 based on the 3D keyword dataset 142, the customized keyword dataset 144, and the user keyword dataset 146. The 3D keyword dataset 142 represents the following ten preselected 3D keywords that are relevant to the design of 3D objects: isometric, 3D render, wireframe, low poly, computer-generated imagery (CGI) edges, split, angle, axis, and circles. The user keyword dataset 146 initially and through the workflow end 214 represents no user keywords, indicating that the user does not enter any new keywords via the suggestion pane 230 during the execution of the exemplar image generation workflow.

As shown, the suggestion pane 230 is entitled "prompt suggestions." The suggestion pane 230 includes selectable versions of the 3D keywords, the design keywords, the style keywords, and the part keywords as well as an interactive GUI element (depicted as a clickable plus sign) that enables optional entry of any number of user keywords. As depicted using bold font, two of the 3D keywords (isometric and 3D render) and three of he parts keywords (nozzle housing, nozzle cap, and nozzle body) are selected by the user during the first iteration.

As described previously herein in conjunction with Figure 1, in response to a final prompt trigger (e.g., a double-click within the final prompt pane 240), the keyword engine 140 generates the selected keyword set 170 that includes the keywords that are selected via the suggestion pane 230. The design exploration application 130 then generates the rephrase prompt 172 based on the selected keyword set 170. The design exploration application 130 executes the prompt-to-text ML model 102 on the rephrase prompt 172 to generate the final text prompt 180.

More precisely, as part of executing the exemplar image generation workflow, the keyword engine 140 generates the selected keyword set 170 that includes isometric, 3D render, nozzle housing, nozzle cap, and nozzle body. The design exploration application 130 generates the rephrase prompt 172 of "put the following together: isometric, 3D render, nozzle housing, nozzle cap, and nozzle body." The design exploration application 130 executes the prompt-to-text ML model 102 on the rephrase prompt 172 to generate the final text prompt 180 of "isometric 3D render of a nozzle housing, nozzle cap, and nozzle body" (depicted in bold italics).

As shown, the final prompt pane 240 includes a copy of the grayed-out image prompt 134 and an editable version of the final text prompt 180. For explanatory purposes, the user does not edit the final text prompt 180. As described previously herein in conjunction with Figure 1, in response to a result trigger (e.g., a double-click within the result pane 250), the design exploration application 130 determines whether the image prompt 134 is specified.

Because the image prompt 134 is not specified, the design exploration application 130 executes the prompt-to-image ML model 106 on the final text prompt 180 to generate the relevant image set 190. In some other embodiments, the image prompt 134 is specified, and the design exploration application 130 executes the prompt-to-image ML model 106 on the final text prompt 180 and the image prompt 134 to generate the relevant image set 190.

As shown, the relevant image set 190 includes, without limitation, an image 290(1) - an image 290(N), where N can be any positive integer. The design exploration application 130 then updates the result pane 250 to include selectable versions of the image 290(1) - the image 290(N), thereby ending the first iteration. The image 290(1) - the image 290(N) are images of different 3D designs for the sprayer that are associated with the keywords isometric 3D render, a nozzle housing, nozzle cap, and nozzle body.

After the workflow end 214, the user optionally selects zero or more of the image 290(1) - the image 290(N). The design exploration application 130 sets the selected image set 198 equal to the selected images. Subsequently, the design exploration application 130 automatically generates and stores in the history 138 a new summary dataset that includes any amount and/or types of data associated with generating the relevant image set 190 and/or the selected image set 198.

For instance, in some embodiments, the new summary dataset includes the image prompt 134, the design intent text 132, the 3D keywords, the design prompt 152, the design keywords, the style prompt 154, the style keywords, the part prompt 156, the part keywords, the selected keyword set 170, the rephrase prompt 172, the final text prompt 180, the relevant image set 190, and the selected image set 198.

Te design exploration application 130 can generate any number (including none) of additional relevant image sets in an iterative fashion, a non-iterative fashion, or any combination thereof during an overall process for generating and evaluating design alternatives for the exemplar 3D object. The design exploration application 130 can update each of the description pane 220, the suggestion pane 230, the final prompt pane 240, the result pane 250, and the history pane 260, any number and/or types of other GUI elements, or any combination any number of times and/in any order while generating each new relevant image set.

Advantageously, as illustrated by Figure 2, the design exploration application 130 enables a user with limited or no knowledge of physics, engineering, generative design, 3D design, and/or design-related nomenclature associated with sprayers to automatically generate images representing design alternatives for a target sprayer.

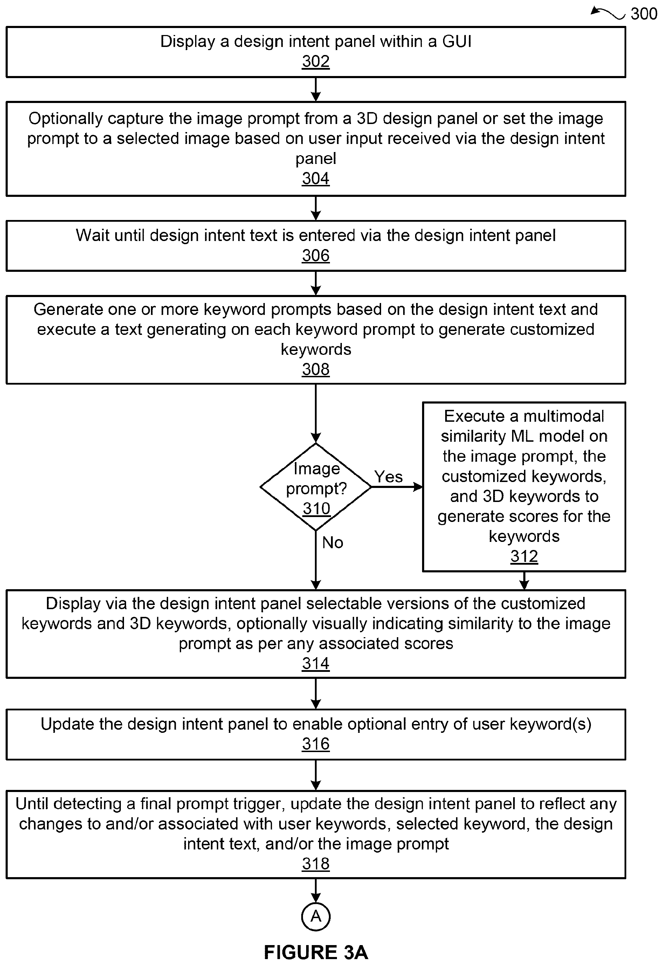

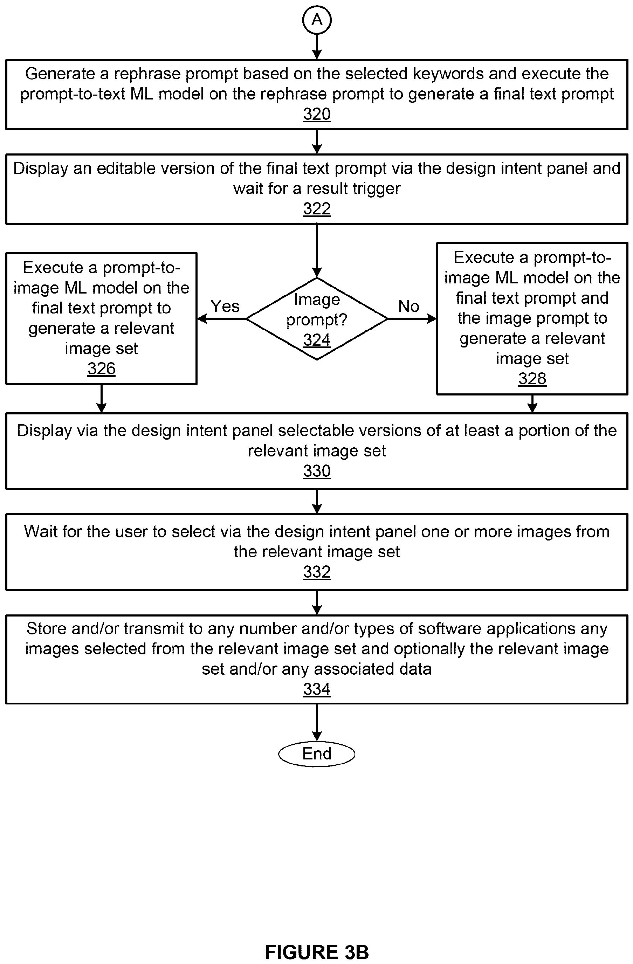

Figures 3A and 3B set forth a flow diagram of method steps for generating images representing design alternatives for 3D objects, according to various embodiments. Although the method steps are described with reference to the systems of Figures 1 and 2, persons skilled in the art will understand that any system configured to implement the method steps, in any order, falls within the scope of the embodiments.

As shown, a method 300 begins at step 302, where the design exploration application 130 displays the design intent panel 124 within the GUI 120. At step 304, the design exploration application 130 optionally captures the image prompt from a 3D design panel 122 or sets the image prompt to a selected image based on user input received via the design intent panel 124. At step 306, the design exploration application 130 waits until design intent text is entered via the design intent panel 124.

At step 308, the design exploration application 130 generates one or more keyword prompts based on the design intent text and executes a prompt-to-text ML model 102 each keyword prompt to generate customized keywords. At step 310, the design exploration application 130 determines whether an image prompt is specified. If, at step 310, the design exploration application 130 determines that an image prompt is not specified, then the method 300 proceeds directly to step 314.

If, however, at step 310, the design exploration application 130 determines that an image prompt is specified, then the method 300 proceeds to step 312. At step 312, the design exploration application 130 executes the multimodal similarity ML model 104 on the image prompt, the customized keywords, and 3D design keywords to generate scores for the keywords.

At step 314, the design exploration application 130 displays via the design intent panel 124 selectable versions of the customized keywords and 3D design keywords, optionally visually indicating similarity to the image prompt as per any associated scores. At step 316, the design exploration application 130 updates the design intent panel 124 to enable optional entry of user keyword(s). At step 318, until detecting a final prompt trigger, the design exploration application 130 updates the design intent panel to reflect any changes to and/or associated with user keywords, selected keyword, the design intent text, and/or the image prompt.

At step 320, the design exploration application 130 generates a rephrase prompt based on the selected keywords and executes the prompt-to-text ML model 102 on the rephrase prompt to generate a final text prompt. At step 322, the design exploration application 130 displays an editable version of the final text prompt via the design intent panel 124 and waits for a result trigger.

At step 324, the design exploration application 130 determines whether an image prompt is specified. If, at step 324, the design exploration application 130 determines that an image prompt is not specified, then the method 300 proceeds to step 326. At step 326, the design exploration application 130, executes the prompt-to-image ML model 106 on the final text prompt to generate a relevant image set. The method 300 then proceeds directly to step 330.

If, however, at step 324, the design exploration application 130 determines that an image prompt is specified, then the method 300 proceeds directly to step 328. At step 328, the design exploration application 130, executes the prompt-to-image ML model 106 on the final text prompt and the image prompt to generate a relevant image set. At step 330, the design exploration application 130 displays via the design intent panel 124 selectable versions of at least a portion of the relevant image set.

At step 332, the design exploration application 130 waits for the user to select via the design intent panel 124 one or more images from the relevant image set. At step 334, the design exploration application 130 stores and/or transmits to any number and/or types of software applications any images selected from the relevant image set and optionally the relevant image set and/or any associated data. The method 300 then terminates.

In sum, the disclosed techniques can be used to generate images representing 3D designs based on quantitative design intentions expressed by users via a GUI. In some em embodiments, a design exploration application 130 displays a design intent panel via a GUI. The design intent panel enables a user to specify design intent text and optionally a image prompt. The design exploration application 130 constructs one or more different keyword prompts based on the design intent text. Each keyword prompt is a request for knowledge on a different aspect of 3D design and/or 3D objects that is relevant to the design intent text. The design exploration application 130 executes a prompt-to-text ML model on each of the keyword prompts to generate customized keywords.

If the image prompt is specified, the design exploration application 130 computes a different score for each customized keyword and each of any number of 3D keywords that are relevant to designing 3D objects. A score of a keyword estimates a similarity between the image prompt and the keyword. To compute a score for a keyword, the design exploration application 130 executes a multimodal similarity ML model 104 on the image prompt and the keyword.

The design exploration application displays within the design intent panel selectable versions of the customized keywords and the 3D keywords. If the image prompt is specified, then the design exploration application 130 visually indicates within the design intent panel the relative scores. The design exploration application also displays within the design intent panel an interactive GUI element that enables the user to enter any number of user keywords. The design exploration application interactively updates selection flags associated with keywords, designates new user keywords, computes scores for new user keywords, displays new user keywords, or any combination thereof in accordance with user input received via the design intent pane until detecting a final prompt trigger.

Subsequently, the design exploration application constructs a rephrase prompt based on the selected keywords. The rephrase prompt is a request to generate a textual prompt that reflects the selected keywords. The design exploration application executes the prompt-to-text ML model on the rephrase prompt to generate a final text prompt. The design exploration application displays within the design intent panel an editable version of the final text prompt and waits for a result trigger.

If an image prompt is specified, then the design exploration application executes a prompt-to-image ML model on the final text prompt and the image prompt to generate a relevant image set. Otherwise, the design exploration application executes the prompt-to-image ML model on the image prompt to generate the relevant image set. Each image included in the relevant image set is a representation of a design alternative for a target 3D design described by the final text prompt. The design exploration application displays via the design intent panel selectable versions of at least a portion of the relevant image set. The design application stores and/or transmits to any number and/or types of software applications any images selected from the relevant image set for further design activities.

At least one technical advantage of the disclosed techniques relative to the prior art is that the disclosed techniques enable users with limited or no knowledge of physics, engineering, and/or generative design to more effectively explore design spaces for 3D objects. In that regard, the disclosed techniques provide an automated process for generating images representing different design alternatives for 3D objects based on user-based design-related intentions expressed via qualitative user input. Because no quantitative user input is required with the disclosed techniques, the likelihood that users having limited or no knowledge of physics, engineering, and/or generative design are able to define proper design spaces when designing and evaluating 3D objects using the disclosed techniques is increased relative to what is commonly achievable using prior art generative design techniques. Accordingly, with the disclosed techniques, 3D objects that align better with the actual design-oriented intentions of users can be more readily generated and manufactured These technical advantages provide one or more technological improvements over prior art approaches.
1. In some embodiments, a computer-implemented method for generating images that represent design alternatives for three-dimensional (3D) objects comprises generating a first keyword prompt based on design intent text that describes at least a first 3D object; executing a first machine learning model on the first keyword prompt to generate a first plurality of keywords; generating a rephrase prompt based on a set of keywords that includes at least one keyword included in the first plurality of keywords; executing the first machine learning model on the rephrase prompt to generate a final text prompt; and executing a second machine learning model on the final text prompt to generate a plurality of images.
2. The computer-implemented method of clause 1, wherein the first keyword prompt comprises a request to list at least one of a design, a style, or a part associated with the design intent text.
3. The computer-implemented method of clauses 1 or 2, further comprising displaying within a graphical user interface a selectable version of a first keyword included in the first plurality of keywords; determining that the first keyword has been selected based on user input received via the graphical user interface; and adding the first keyword to the first set of keywords.
4. The computer-implemented method of any of clauses 1-3, further comprising displaying within a graphical user interface a selectable version of a first keyword associated with 3D design; determining that the first keyword has been selected based on user input received via the graphical user interface; and adding the first keyword to the first set of keywords.
5. The computer-implemented method of any of clauses 1-4, further comprising executing a multimodal machine learning model on an image prompt and a first keyword included in the first plurality of keywords to compute a first score; and displaying a selectable version of the first keyword within a graphical user interface, wherein at least one visual characteristic of the selectable version of the first keyword is based on the first score.
6. The computer-implemented method of any of clauses 1-5, wherein the at least one visual characteristic comprises at least one of a color, an intensity, an opacity, a size, or a position.
7. The computer-implemented method of any of clauses 1-6 wherein generating the rephrase prompt comprises constructing a request to combine every keyword included in the set of keywords.
8. The computer-implemented method of any of clauses 1-7, further comprising executing the second machine learning model on one or more image prompts when generating the plurality of images.
9. The computer-implemented method of any of clauses 1-8, further comprising capturing a first image prompt included in the one or more image prompts from a 3D model displayed within a graphical user interface.
10. The computer-implemented method of any of clauses 1-9, wherein the first machine learning model comprises a generative prompt-to-text machine learning model, and the second machine learning model comprises a generative prompt-to-image machine learning model.
11. In some embodiments, one or more non-transitory computer readable media include instructions that, when executed by one or more processors, cause the one or more processors to generate images that represent design alternatives for three-dimensional (3D) objects by performing the steps of generating a first keyword prompt based on design intent text that describes at least at least a first 3D object; executing a first machine learning model on the first keyword prompt to generate a first plurality of keywords; generating a rephrase prompt based on a set of keywords that includes at least one keyword included in the first plurality of keywords; executing the first machine learning model on the rephrase prompt to generate a final text prompt; and executing a second machine learning model on the final text prompt to generate a plurality of images.
12. The one or more non-transitory computer readable media of clause 11, wherein the first keyword prompt comprises a request to list at least one of a design, a style, or a part associated with the design intent text.
13. The one or more non-transitory computer readable media of clauses 11 or 12, further comprising displaying within a graphical user interface a selectable version of a first keyword included in the first plurality of keywords; determining that the first keyword has been selected based on user input received via the graphical user interface; and adding the first keyword to the first set of keywords.
14. The one or more non-transitory computer readable media of any of clauses 11-13, further comprising designating a first word or a first phrase as a first user keyword based on user input received via a graphical user interface; and adding the first user keyword to the first set of keywords.
15. The one or more non-transitory computer readable media of any of clauses 11-14, further comprising executing a multimodal machine learning model on an image prompt and a first keyword included in the first plurality of keywords to compute a first score; and displaying a selectable version of the first keyword within a graphical user interface, wherein at least one visual characteristic of the selectable version of the first keyword is based on the first score.
16. The one or more non-transitory computer readable media of any of clauses 11-15, wherein the first score estimates a similarity between the image prompt and the first keyword.
17. The one or more non-transitory computer readable media of any of clauses 11-16, wherein generating the rephrase prompt comprises constructing a request to combine every keyword included in the set of keywords.
18. The one or more non-transitory computer readable media of any of clauses 11-17, further comprising executing the second machine learning model on one or more image prompts when generating the plurality of images.
19. The one or more non-transitory computer readable media of any of clauses 11-18, further comprising setting a first image prompt included in the one or more image prompts equal to at least a portion of an image displayed within a graphical user interface to recursively generate the plurality of images.
20. In some embodiments, a system comprises one or more memories storing instructions and one or more processors coupled to the one or more memories that, when executing the instructions, perform the steps of generating a first keyword prompt based on design intent text that describes at least a first 3D object; executing a first machine learning model on the first keyword prompt to generate a first plurality of keywords; generating a rephrase prompt based on a set of keywords that includes at least one keyword included in the first plurality of keywords; executing the first machine learning model on the rephrase prompt to generate a final text prompt; and executing a second machine learning model on the final text prompt to generate a plurality of images.

Any and all combinations of any of the claim elements recited in any of the claims and/or any elements described in this application, in any fashion, fall within the contemplated scope of the present invention and protection.

The descriptions of the various embodiments have been presented for purposes of illustration, but are not intended to be exhaustive or limited to the embodiments disclosed. Many modifications and variations will be apparent to those of ordinary skill in the art without departing from the scope and spirit of the described embodiments.

Aspects of the present embodiments may be embodied as a system, method or computer program product. Accordingly, aspects of the present disclosure may take the form of an entirely hardware embodiment, an entirely software embodiment (including firmware, resident software, micro-code, etc.) or an embodiment combining software and hardware aspects that may all generally be referred to herein as a "module" or "system." Furthermore, aspects of the present disclosure may take the form of a computer program product embodied in one or more computer readable medium(s) having computer readable program code embodied thereon.

Any combination of one or more computer readable medium(s) may be utilized. The computer readable medium may be a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples (a non-exhaustive list) of the computer readable storage medium would include the following: an electrical connection having one or more wires, a portable computer diskette, a hard disk, a random access memory (RAM), a read-only memory (ROM), an erasable programmable read-only memory, Flash memory, an optical fiber, a portable compact disc read-only memory, an optical storage device, a magnetic storage device, or any suitable combination of the foregoing. In the context of this document, a computer readable storage medium may be any tangible medium that can contain, or store a program for use by or in connection with an instruction execution system, apparatus, or device.

Aspects of the present disclosure are described above with reference to flowchart illustrations and/or block diagrams of methods, apparatus (systems) and computer program products according to embodiments of the disclosure. It will be understood that each block of the flowchart illustrations and/or block diagrams, and combinations of blocks in the flowchart illustrations and/or block diagrams, can be implemented by computer program instructions. These computer program instructions may be provided to a processor of a general purpose computer, special purpose computer, or other programmable data processing apparatus to produce a machine. The instructions, when executed via the processor of the computer or other programmable data processing apparatus, enable the implementation of the functions/acts specified in the flowchart and/or block diagram block or blocks. Such processors may be, without limitation, general purpose processors, special-purpose processors, application-specific processors, or field-programmable gate arrays.

The flowchart and block diagrams in the figures illustrate the architecture, functionality, and operation of possible implementations of systems, methods and computer program products according to various embodiments of the present disclosure. In this regard, each block in the flowchart or block diagrams may represent a module, segment, or portion of code, which comprises one or more executable instructions for implementing the specified logical function(s). It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts, or combinations of special purpose hardware and computer instructions.

While the preceding is directed to embodiments of the present disclosure, other and further embodiments of the disclosure may be devised without departing from the basic scope thereof, and the scope thereof is determined by the claims that follow.

## Claims

1. A computer-implemented method for generating images that represent design alternatives for three-dimensional (3D) objects, the method comprising:
generating a first keyword prompt based on design intent text that describes at least a first 3D object;
executing a first machine learning model on the first keyword prompt to generate a first plurality of keywords;
generating a rephrase prompt based on a set of keywords that includes at least one keyword included in the first plurality of keywords;
executing the first machine learning model on the rephrase prompt to generate a final text prompt; and
executing a second machine learning model on the final text prompt to generate a plurality of images.

2. The computer-implemented method of claim 1, wherein the first keyword prompt comprises a request to list at least one of a design, a style, or a part associated with the design intent text.

3. The computer-implemented method of claim 1 or 2, further comprising:
displaying within a graphical user interface a selectable version of a first keyword included in the first plurality of keywords;
determining that the first keyword has been selected based on user input received via the graphical user interface; and
adding the first keyword to the first set of keywords.

4. The computer-implemented method of any preceding claim, further comprising:
displaying within a graphical user interface a selectable version of a first keyword associated with 3D design;
determining that the first keyword has been selected based on user input received via the graphical user interface; and
adding the first keyword to the first set of keywords.

5. The computer-implemented method of any preceding claim, further comprising:
executing a multimodal machine learning model on an image prompt and a first keyword included in the first plurality of keywords to compute a first score; and
displaying a selectable version of the first keyword within a graphical user interface, wherein at least one visual characteristic of the selectable version of the first keyword is based on the first score.

6. The computer-implemented method of claim 5, wherein the at least one visual characteristic comprises at least one of a color, an intensity, an opacity, a size, or a position.

7. The computer-implemented method of any preceding claim, wherein generating the rephrase prompt comprises constructing a request to combine every keyword included in the set of keywords.

8. The computer-implemented method of any preceding claim, further comprising executing the second machine learning model on one or more image prompts when generating the plurality of images.

9. The computer-implemented method of claim 8, further comprising capturing a first image prompt included in the one or more image prompts from a 3D model displayed within a graphical user interface.

10. The computer-implemented method of any preceding claim, wherein the first machine learning model comprises a generative prompt-to-text machine learning model, and the second machine learning model comprises a generative prompt-to-image machine learning model.

11. A computer program product comprising instructions that, when executed by one or more processors, cause the one or more processors to generate images that represent design alternatives for three-dimensional (3D) objects by performing the steps of any of claims 1 to 10.

12. A system comprising:
one or more memories storing instructions; and
one or more processors coupled to the one or more memories that, when executing the instructions, perform the steps of any of claims 1 to 10.
